# EUROPEAN PATENT APPLICATION

(11) **EP 4 773 764 A2**
(43) Date of publication of application: **08.07.2026**
(21) Application number: 26179943.1
(22) Date of filing: 24.04.2025
(51) Int. Cl.: H10K 30/40

(54) **SOLAR CELL AND TANDEM SOLAR CELL**

(30) Priority: 11.06.2024 CN 202410748596
(62) Divisional of application: 25172378.9
(71) Applicant: Zhejiang Jinko Solar Co., Ltd., Haining, Zhejiang 314416 (CN)
(72) Inventor: ZHANG, Bike, Haining, 314416 (CN); ZHANG, Xinyu, Haining, 314416 (CN); WANG, Ruhao, Haining, 314416 (CN); JIN, Jingsheng, Haining, 314416 (CN); LIAO, Guangming, Haining, 314416 (CN); QIN, Jiani, Haining, 314416 (CN); LIU, Changming, Haining, 314416 (CN)
(74) Representative: Müller Schupfner & Partner Patent- und Rechtsanwaltspartnerschaft mbB (Muc)

(57) **Abstract**

The present disclosure relates to a solar cell and a tandem solar cell. The solar cell includes a substrate, a tunnel dielectric layer, a doped conductive layer and at least one first electrode. A first surface of the substrate includes metallization regions and non-metallization regions. The metallization region is provided with a first texture structure, the first texture structure includes a first recess. The non-metallization region is provided with a second texture structure, the second texture structure includes a second recess. An average one-dimensional size of a bottom surface of the first recess is smaller than an average one-dimensional size of a bottom surface of the second recess. The metallization region includes first regions and second regions, the first regions are arranged at intervals in a first direction, the second regions are connected between adjacent first regions, and the second regions are arranged at intervals in a second direction. The tunnel dielectric layer is arranged on a surface of the first texture structure. The doped conductive layer is arranged on a side of the tunnel dielectric layer away from the substrate. The first electrode includes a plurality of finger electrodes, and the finger electrodes are electrically connected with the doped conductive layer and arranged corresponding to the first regions, so as to facilitate the improvement of the photoelectric conversion efficiency of the solar cell.

## Description

### TECHNICAL FIELD

The present disclosure relates to the technical field of photovoltaic cells and, in particular, to a solar cell and a tandem solar cell.

### BACKGROUND

A solar cell is a photoelectric semiconductor sheet directly generating electricity by using sunlight, which is also called as "solar chip" or "photocell". The solar cell can instantly output a voltage and generate a current when a circuit is formed, as long as being illuminated by light with a certain illumination condition.

In order to reduce the electrical loss and the optical loss of the solar cell, a polishing process is generally required on a back surface of the solar cell. The back-surface polishing process mainly includes the step of polishing a boron-doped pyramid-shaped structure on the back surface by using a wet chemical method, so as to increase internal reflection of light, reduce the surface recombination rate of carriers, and thereby improving the photoelectric conversion efficiency of the solar cell. However, in order to improve the photoelectric conversion efficiency of the solar cell, surface morphology of film layers in the solar cell is required to be further investigated.

### SUMMARY

In view of this, the present disclosure provides a solar cell and a tandem solar cell, so as to facilitate the improvement of the photoelectric conversion efficiency of the solar cell.

In a first aspect, the present disclosure provides a solar cell, including a substrate, a tunnel dielectric layer, a doped conductive layer and a first electrode. A first surface of the substrate includes metallization regions and non-metallization regions. The metallization region is provided with a first texture structure, the first texture structure includes a first recess. The non-metallization region is provided with a second texture structure, the second texture structure includes a second recess. An average one-dimensional size of a bottom surface of the first recess is smaller than an average one-dimensional size of a bottom surface of the second recess. The metallization region includes first regions and second regions, the first regions are arranged at intervals in a first direction, the second regions are connected between adjacent first regions, and the second regions are arranged at intervals in a second direction. The tunnel dielectric layer is arranged on a surface of the first texture structure. The doped conductive layer is arranged on a side of the tunnel dielectric layer away from the substrate. The first electrode includes a plurality of finger electrodes, and the finger electrodes are electrically connected with the doped conductive layer and arranged corresponding to the first regions.

In one or more embodiments, the average one-dimensional size of the bottom surface of the first recess ranges from 5 µm to 10 µm; and a depth of the first recess ranges from 0.05 µm to 2 µm.

In one or more embodiments, the average one-dimensional size of the bottom surface of the second recess ranges from 10 µm to 25 µm; and a depth of the second recess ranges from 0.05 µm to 2 µm.

In one or more embodiments, a sectional shape of the first recess and/or the second recess is one or more of a diamond shape, a square shape, and a trapezoid shape.

In one or more embodiments, in the first texture structure, at least part of projections of bottoms of at least two first recesses in a thickness direction of the substrate overlap with or abut against each other.

In one or more embodiments, in the second texture structure, at least part of projections of bottoms of at least two second recesses in the thickness direction of the substrate overlap with or abut against each other.

In one or more embodiments, the first electrode further includes a plurality of bus electrodes, and the bus electrodes are arranged on sides of the finger electrodes away from the doped conductive layer and electrically connected to the finger electrodes. The bus electrodes are arranged at intervals along the second direction and correspond to the second regions.

In one or more embodiments, a top surface of the metallization region protrudes relative to a top surface of the non-metallization region in the thickness direction of the substrate.

In one or more embodiments, in the thickness direction of the substrate, a height difference between the top surface of the metallization region and the top surface of the non-metallization region ranges from 1 µm to 10 µm.

In one or more embodiments, the first surface further includes transition regions, the transition region are connected between the metallization regions and the adjacent non-metallization regions, and the transition region is provided with holes. A diameter of each of the holes range from 0.5 µm to 5 µm, and a depth of each of the holes range from 0.5 µm to 2 µm.

**In** one or more embodiments, the transition regions are arranged obliquely relative to the metallization regions and the non-metallization regions.

**In** one or more embodiments, the solar cell further includes first passivation layers arranged on the side of the doped conductive layer away from the tunnel dielectric layer and on a surface of the second texture structure.

**In** a second aspect, the present disclosure provides a tandem solar cell, including a bottom cell, a top cell and an intermediate connection layer. The bottom cell is the solar cell according to any one of the above embodiments. The top cell is one of a perovskite solar cell, a donor-acceptor cell, a cadmium telluride solar cell, a copper indium gallium selenide solar cell or a gallium arsenide solar cell. The intermediate connection layer is connected between the bottom cell and the top cell.

**In** a third aspect, the present disclosure provides a photovoltaic module, including a solar cell string, a packaging layer and a cover plate. The solar cell string is formed by connecting a plurality of solar cells according to any one of the above embodiments. The packaging layer is configured to cover a surface of the solar cell string. The cover plate is configured to cover a surface of the packaging layer away from the solar cell string.

It is to be understood that both the foregoing general description and the following detailed description are exemplary only and are not intended to limit the present disclosure.

### BRIEF DESCRIPTION OF DRAWINGS

To better describe the technical solutions in embodiments of the present disclosure, the following briefly describes the accompanying drawings required for the embodiments. It is appreciated that, the accompanying drawings in the following description show merely some embodiments of the present disclosure, and person of ordinary skill in the art may still derive other drawings from these accompanying drawings without creative efforts.
FIG. 1 is a schematic structural diagram of a solar cell according to one or more embodiments of the present disclosure;
FIG. 2 is a schematic structural diagram of a substrate of the solar cell according to one or more embodiments of the present disclosure;
FIG. 3 is a scanning electron microscope (SEM) image of a first surface of the substrate of the solar cell according to one or more embodiments of the present disclosure;
FIG. 4 is a top view of the solar cell according to one or more embodiments of the present disclosure;
FIG. 5 is a sectional view of the solar cell in FIG. 4 taken along line A-A;
FIG. 6 is a sectional view of the substrate of the solar cell according to one or more embodiments of the present disclosure;
FIG. 7 is a scanning electron microscope image of a first texture structure on the substrate of the solar cell according to one or more embodiments of the present disclosure;
FIG. 8 is a scanning electron microscope image of a second texture structure on the substrate of the solar cell according to one or more embodiments of the present disclosure;
FIG. 9 is a scanning electron microscope image of the first texture structure on the substrate of the solar cell according to one or more embodiments of the present disclosure at another perspective;
FIG. 10 is a scanning electron microscope image of the first surface of the substrate of the solar cell according to one or more embodiments of the present disclosure at another perspective;
FIG. 11 is a sectional view of the substrate of the solar cell according to one or more embodiments of the present disclosure;
FIG. 12 is a top view of a first passivation layer of the solar cell according to one or more embodiments of the present disclosure;
FIG. 13 is a top view of the first passivation layer of the solar cell according to one or more other embodiments of the present disclosure;
FIG. 14 is a sectional view of the first passivation layer of the solar cell according to one or more embodiments of the present disclosure;
FIG. 15 is a sectional view of the solar cell at a metallization region according to one or more embodiments of the present disclosure;
FIG. 16 is a sectional view of the solar cell at a non-metallization region according to the present disclosure;
FIG. 17 is a schematic structural diagram of a tandem solar cell according to one or more embodiments of the present disclosure; and
FIG. 18 is a schematic structural diagram of a photovoltaic module according to one or more embodiments of the present disclosure.

The accompanying drawings, which are incorporated in and constitute a part of the specification, illustrate embodiments consistent with the present disclosure and, together with the description, serve to explain the principles of the present disclosure.

### DESCRIPTION OF EMBODIMENTS

In order to better understand the technical solution of the present disclosure, embodiments of the present disclosure are described in detail below with reference to the accompanying drawings.

In the description of the present disclosure, unless explicitly specified and limited otherwise, the terms "first" and "second" are used for descriptive purposes only and are not to be construed as indicating or implying relative importance. The term "plurality" means two or more unless specified or explained otherwise. The terms "connected", "fixed", or the like, are to be construed broadly, and "connected" may be, for example, fixed connections, detachable connections, integral connections or electrical connections, and may also be direct connections or indirect connections via intermediate components. For person of ordinary skill in the art, the specific meanings of the above terms in the present disclosure can be understood based on specific scenarios.

The terminology used in embodiments of the present disclosure is for the purpose of describing particular embodiments only and is not intended to limit the present disclosure. As used in embodiments of the present disclosure and the appended claims, "a" and "the" in singular forms mean including plural forms, unless clearly indicated in the context otherwise.

It should be understood that the term "and/or" as used herein is merely an association relationship describing associated objects, indicating that three relationships may exist. For example, A and/or B indicates that there are three cases of A alone, A and B together, and B alone. In addition, the character "/" herein generally means that associated objects before and after "/"are in an "or" relationship.

It should be noted that the directional terms "upper", "lower", "left", "right", etc. described in embodiments of the present disclosure are used at the perspective shown in the drawings, and should not be construed as providing any limitation to the embodiments of the present disclosure. Furthermore, in the context, it should also be understood that when an element is referred to as being connected "above" or "below" another element, it can be directly connected "above" or "below" the other element or be indirectly connected "above" or "below" the other element via intervening elements.

A solar cell is a photoelectric semiconductor sheet directly generating electricity by using sunlight, which is also called as "solar chip" or "photocell". The solar cell can instantly output a voltage and generate a current when a circuit is formed, as long as being illuminated by light with a certain illumination condition.

In order to reduce the electrical loss and the optical loss of the solar cell, a polishing process is generally required on a back surface of the solar cell. The back-surface polishing process mainly includes the step of polishing a boron-doped pyramid-shaped structure on the back surface by using a wet chemical method, so as to increase internal reflection of light, reduce the surface recombination rate of carriers, and thereby improving the photoelectric conversion efficiency of the solar cell. However, in order to improve the photoelectric conversion efficiency of the solar cell, surface morphology of film layers in the solar cell is required to be further investigated.

Based on this, the present disclosure provides a solar cell, a tandem solar cell and a photovoltaic module, so as to facilitate the improvement of the photoelectric conversion efficiency of the solar cell. The solar cell may be applied to various solar cell structures, including but not limited to a tunnel oxide passivated contact (TOPCon) cell, an interdigitated back contact (IBC) cell, a passivated emitter rear cell (PERC), or the like, which is not limited herein.

For the sake of easy understanding, for example, the following description will be provided with the TOPCon cell as the solar cell.

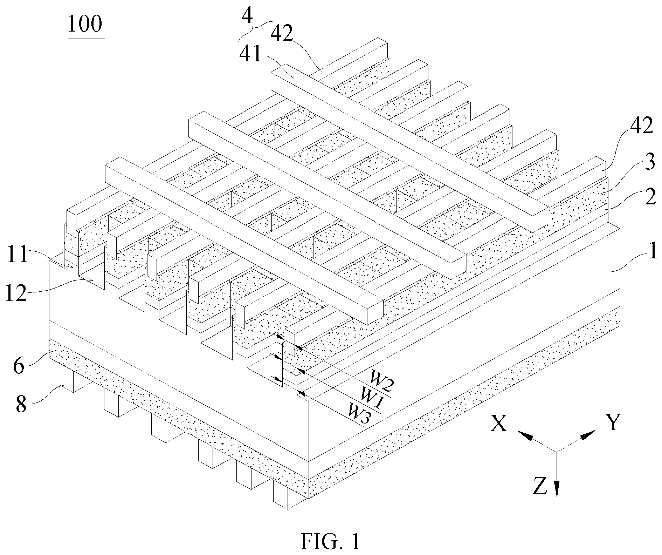

As shown in FIG. 1, the solar cell 100 includes a substrate 1, a tunnel dielectric layer 2, a doped conductive layer 3 and at least one first electrode 4.

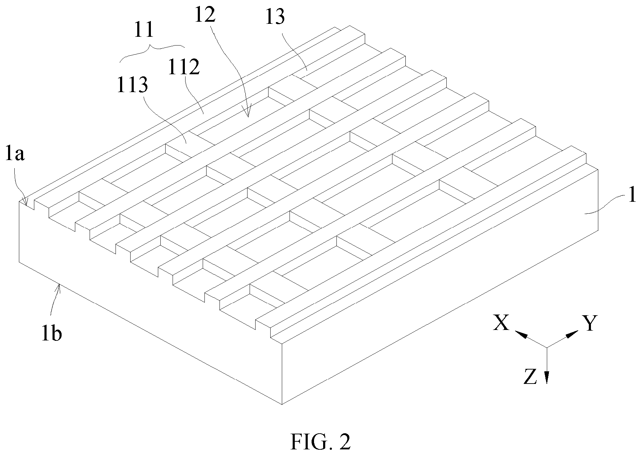

As shown in FIG. 2, the substrate 1 is configured to receive incident light and produce photo-generated carriers. In some embodiments, the substrate 1 is a silicon substrate which may contain one or more of monocrystalline silicon, polycrystalline silicon, amorphous silicon, or microcrystalline silicon. In some other embodiments, the material of the substrate 1 may also be silicon carbide, an organic material or a multi-component compound. The multi-component compound may include, but is not limited to, perovskite, gallium arsenide, cadmium telluride, copper indium selenide, or the like. For example, the substrate 1 in the present disclosure is a monocrystalline silicon substrate. The substrate 1 has a doping element, the conductivity type of the doping element may be N-type or P-type. The N-type element may be a group-V element, such as phosphorus (P), bismuth (Bi), antimony (Sb), or arsenic (As). The P-type element may be a group-III element, such as boron (B), aluminium (Al), gallium (Ga), or indium (In). For example, when the substrate 1 is a P-type silicon substrate, the conductivity type of the doping element therein is P-type. For another example, when the substrate 1 is an N-type silicon substrate, the conductivity type of the doping element therein is N-type. In some embodiments of the present disclosure, the substrate 1 is an N-type silicon substrate, so as to improve the conversion efficiency of the solar cell 100 and reduce the manufacturing cost.

As shown in FIG. 2 to FIG. 5, the substrate 1 includes a first surface 1a (for example, backlight surface) and a second surface 1b (for example, light receiving surface) which are oppositely arranged. The first surface 1a includes metallization regions 11 and non-metallization regions 12. That is, the first surface is divided as a plurality of metallization regions and non-metallization regions in an alternating arrangement, as shown in FIG. 1 and FIG. 2. The metallization region 11 includes first regions 112 and second regions 113. The first regions 112 are arranged at intervals in a first direction X, the second regions 113 are connected between adjacent first regions 112, and the second regions 113 are arranged at intervals in a second direction Y. An included angle is formed between the first direction X and the second direction Y. In some embodiments, the first direction X and the second direction Y may be perpendicular to each other, or have an included angle smaller than 90 degrees, which may be, for example, 60 degrees, 45 degrees, 30 degrees, or the like, as long as the first direction X and the second direction Y are not aligned in the same direction. For convenience of description and understanding, in some embodiments, the first direction X and the second direction Y are perpendicular to each other as an example. In specific applications, the included angle between the first direction X and the second direction Y may be adjusted according to actual needs and application scenarios, which is not limited herein.

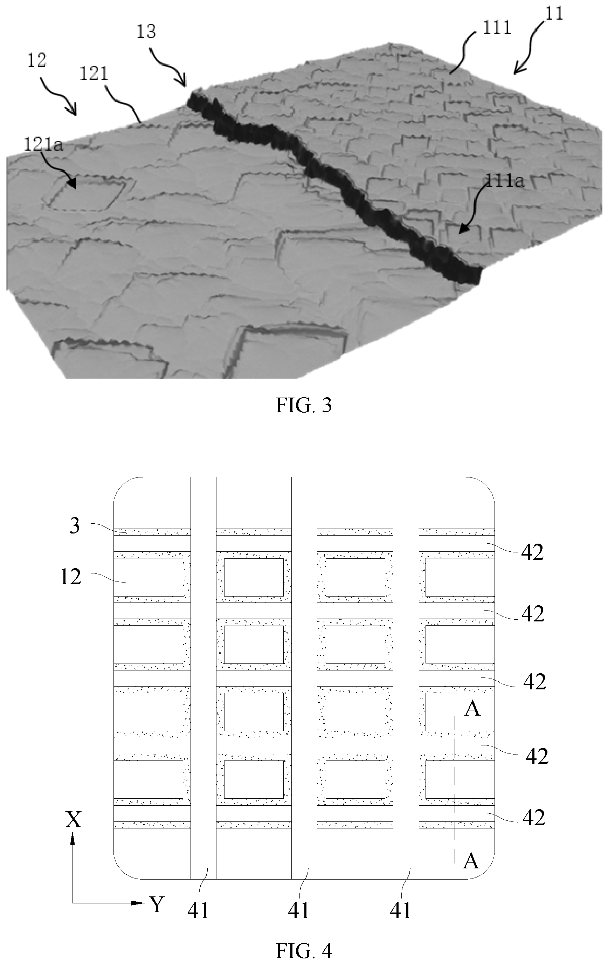

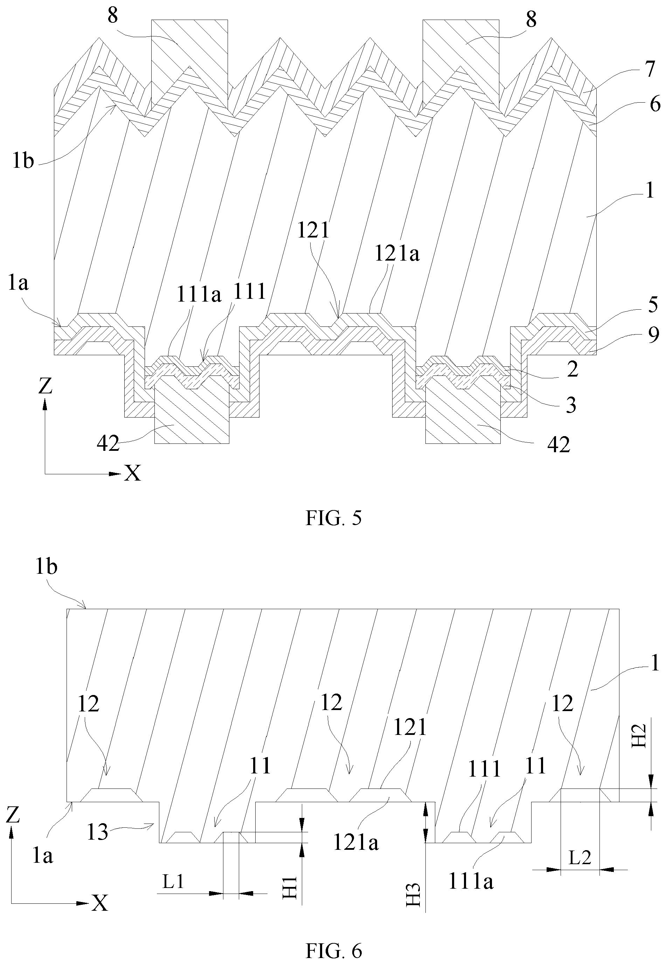

As shown in FIG. 3 and FIG. 5, the metallization region 11 is provided with a first texture structure 111, and the first texture structure 111 includes a first recess 111a. The non-metallization region 12 is provided with a second texture structure 121, and the second texture structure 121 includes a second recess 121a. An average one-dimensional size of a bottom surface of the first recess 111a is smaller than that of a bottom surface of the second recess 121a.

It should be noted that, in some embodiments, a laser etching method or a chemical etching method may be used to form the first texture structure 111 on the metallization region 11 of the first surface 1a and form the second texture structure on the non-metallization region 12. The average one-dimensional sizes of the bottom surfaces of the first recess 111a and the second recess 121a may be, for example, lengths, widths, diagonal lengths, circle diameters, or the like, of the surfaces, which is not limited herein. In some examples, calibrations on a film surface may be directly performed by a test instrument (optical microscope, atomic force microscope, scanning electron microscope, transmission electron microscope, or the like) when measuring an average one-dimensional size of a top surface of a non-pyramidal texture structure. For those skilled in the art, the average value can be determined based on an average of several (e.g., 4 or more) measured one-dimensional sizes of the first recesses acquired in random regions. Similarly, the average value can be determined based on an average of several (e.g., 4 or more) measured one-dimensional sizes of the second recesses acquired in random regions. For example, the measuring apparatus includes but not limited to a microscope (SEM, TEM, LSCM, AFM, etc).

As shown in FIG. 1 and FIG. 5, the tunnel dielectric layer 2 is arranged on a surface of the first texture structure 111. The tunnel dielectric layer 2 reduces the density of the interface part between the substrate 1 and the doped conductive layer 3 through chemical passivation, thus reducing recombination of minority of carriers and holes, and improving the passivation effect on the first surface 1a of the substrate. The tunnel dielectric layer 2 can enable majority of carriers to tunnel into the doped conductive layer 3, so that the majority of carriers are transversely transmitted in the doped conductive layer 3, thus facilitating the collection of the carriers by the first electrode 4, and thereby facilitating the increase of the open-circuit voltage and the short-circuit current of the solar cell 100.

The tunnel dielectric layer 2 may have a single-layer or stacked-layer structure of one or more of dielectric materials with tunneling effect, such as silicon oxide, silicon nitride, silicon oxynitride, nanocrystalline silicon, intrinsic amorphous silicon, intrinsic polycrystalline silicon, or the like. In other embodiments, the tunnel dielectric layer 2 may also be a silicon nitride layer containing oxygen, a silicon carbide layer containing oxygen, or the like. For example, the tunnel dielectric layer 2 may be an ultra-thin silicon oxide layer, so that the tunnel dielectric layer 2 has a good passivation characteristic, and the carriers can more easily tunnel through. A thickness of the tunnel dielectric layer 2 may generally range from 1 nm to 2 nm, and may be specifically set according to actual requirements, which is not limited herein. In some implementations, the tunnel layer may be formed on the first surface 1a side of the substrate 1 by using an ozone oxidation method, a high-temperature thermal oxidation method, a nitric acid oxidation method, a chemical vapor deposition method, or a low pressure chemical vapor deposition (LPCVD) method.

As shown in FIG. 1 and FIG. 5, the doped conductive layer 3 is arranged on a side of the tunnel dielectric layer 2 away from the substrate 1. The doped conductive layer 3 can be used as a field passivation layer, and the doped conductive layer 3 and the tunnel dielectric layer 2 jointly form a passivation contact structure, thus further improving the passivation effect on the surface of the substrate 1. The doping element in the doped conductive layer 3 is the same as that in the substrate 1, and a concentration difference is formed between the doping elements of the doped conductive layer and the substrate 1, so that a high-low junction is formed. The doped conductive layer 3 can be in good contact with the first electrode 4, and energy band bending can be formed on the surface of the substrate 1, thus realizing selective transmission of the carriers, and reducing the recombination loss. For example, the doped conductive layer 3 may be deposited on a surface of the tunnel dielectric layer 2 by using any one of a physical vapor deposition method, a chemical vapor deposition method, a plasma enhanced chemical vapor deposition (PECVD) method, or an atomic layer deposition method. In a thickness direction Z, a thickness of the doped conductive layer 3 may range from 100 nm to 200 nm. For example, the thickness of the doped conductive layer 3 may be 100 nm, 120 nm, 140 nm, 160 nm, 180 nm, 200 nm, or the like, and may be specifically set according to actual requirements, which is not limited herein.

As shown in FIG. 1 and FIG. 5, the first electrode 4 is configured to collect and gather the current of the solar cell 100. The first electrode 4 is arranged on a side of the doped conductive layer 3 away from the tunnel dielectric layer 2, and the first electrode 4 and the doped conductive layer 3 can be in direct or indirect contact to form an electrical connection. For example, the first electrode 4 may be prepared by screen printing and sintering. In some embodiments, metal paste for preparing the first electrode 4 may be one or more of aluminium, silver, gold, nickel, molybdenum, or copper, which is not limited herein.

In some embodiments, as shown in FIG. 1 and FIG. 5, the first electrode 4 includes a plurality of finger electrodes 42. The finger electrodes 42 are arranged on the side of the doped conductive layer 3 away from the tunnel dielectric layer 2 and electrically connected with the doped conductive layer 3. The finger electrodes 42 are arranged at intervals along the first direction X and correspond to the first regions 112.

In some embodiments, as shown in FIG. 1 to FIG. 5, the metallization region 11 of the substrate 1 is a region directly facing the first electrode 4, and the non-metallization region 12 is a region not directly facing the first electrode 4. The average one-dimensional size of the first recess 111a on the metallization region 11 forming the first texture structure 111 is small, so that the ratio of the actual surface area to the plane area of the first surface 1a in the metallization region 11 is large. Therefore, the areas of the tunnel dielectric layer 2, the doped conductive layer 3 and the finger electrode 42 formed on the metallization region 11 are increased, thus increasing the area of contact between the doped conductive layer 3 and the finger electrode 42 on the metallization region 11. The first recess 111a can be better filled with the metal paste for preparing the first electrode 4, thereby improving the performance of metal contact between the doped conductive layer 3 and the finger electrode 42. In addition, the average one-dimensional size of the second recess 121a on the non-metallization region 12 forming the second texture structure 121 is large, so that the ratio of the actual surface area to the plane area of the first surface 1a in the non-metallization region 12 is small, thereby making the first surface 1a in the non-metallization region 12 more smooth, reducing recombination points on the first surface 1a in this region, reducing the recombination rate, and thus improving the surface passivation effect on the non-metallization region 12. As a result, the conversion efficiency of the solar cell 100 is improved.

As shown in FIG. 1 and FIG. 5, the tunnel dielectric layer 2 and the doped conductive layer 3 are only arranged in the metallization region 11, so that the performance of metal contact with the first electrode 4 can be improved, and the transmission of the carriers is facilitated. Light parasitic absorption on the surface of the non-metallization region 12 can be reduced by arranging no tunnel dielectric layer 2 and no doped conductive layer 3 in the non-metallization region 12, thereby further improving the photoelectric conversion efficiency of the solar cell 100.

In addition, the finger electrodes 42 are arranged to directly face the first regions 112 of the metallization region 11, and are electrically connected with the doped conductive layers 3 arranged on the first regions 112, so as to realize the collection of the photo-generated carriers. The carriers between the doped conductive layers 3 on adjacent first regions 112 can be transversely transmitted in the first direction X through the doped conductive layers 3 arranged on the second regions 113, thereby improving the transverse transmission capability of the solar cell 100.

As shown in FIG. 1, in the first direction X, a width W1 of the doped conductive layer 3 located above the first region 112 may range from 100 µm to 600 µm to ensure that the width W1 of the doped conductive layer 3 is greater than or equal to a width W2 of the finger electrode 42, thereby improving the metal contact between the doped conductive layer 3 and the finger electrode 42. The width W1 of the doped conductive layer 3 located above the first region 112 may be 100 µm, 200 µm, 300 µm, 400 µm, 500 µm, 600 µm, or the like. The width W1 thereof may be other values within the above range, and may be specifically set according to actual requirements, which is not limited herein.

As shown in FIG. 1, in the second direction Y, a width of the doped conductive layer 3 located above the second region 113 may range from 150 µm to 600 µm, so as to improve the effect of carrier transmission by the doped conductive layer 3 above the second region 113 in the second direction Y. The width of the doped conductive layer 3 located above the second region 113 may be 150 µm, 200 µm, 300 µm, 400 µm, 500 µm, 600 µm, or the like. The width thereof may be other values within the above range, and may be specifically set according to actual requirements, which is not limited herein.

It should be noted that, as shown in FIG. 1, the metallization region 11 and the non-metallization region 12 are termed with respect to a position of a metal electrode. That is, the metallization region 11 is a region on the substrate 1 corresponding to the growth position of the metal electrode, but sizes thereof do not completely correspond to each other. The projection area of the metallization region 11 in the thickness direction Z may be greater than or equal to the projection area of the metal electrode in the corresponding region in the thickness direction Z, to ensure that the metallization region 11 is large enough, so that the metal electrode may be formed in this region in a metallization process, thereby reducing the preparation difficulty.

In some embodiments, as shown in FIG. 1 and FIG. 2, in the first direction X, a width W3 of the first region 112 may be 2 to 25 times of the width W2 of the finger electrode 42 correspondingly arranged in this region, to ensure that the first region 112 is large enough, so that the doped conductive layer 3 formed above the first region 112 may have a large surface area, thereby enabling the finger electrode 42 to be formed in the first region 112 during a metallization process, and ensuring that the finger electrode 42 and the doped conductive layer 3 can form a stable electrical connection to improve the preparation efficiency. W3 may be 2 times, 4 times, 6 times, 8 times, 10 times, 12 times, 15 times, or the like, of W2, or may be other values within the above range, or may be specifically set according to actual requirements, which is not limited herein.

In some embodiments, as shown in FIG. 1 and FIG. 4, the first electrode 4 further includes a plurality of bus electrodes 41. The bus electrodes 41 are arranged on sides of the finger electrodes 42 away from the doped conductive layer 3 and electrically connected with the finger electrodes 42. The bus electrodes 41 are arranged at intervals in the second direction Y and correspond to the second regions 113.

In some embodiments, as shown in FIG. 1 and FIG. 4, the bus electrode 41 may gather the current collected by the finger electrode 42, and may lead the current out of the solar cell. The bus electrode 41 is arranged corresponding to the second region 113, so that the bus electrode 41 may be limited by the second region 113, thereby facilitating subsequent preparation of the bus electrode 41, reducing process steps, and improving the preparation efficiency.

In some embodiments, as shown in FIG. 3, FIG. 5 and FIG. 6, the average one-dimensional size L1 of the bottom surface of the first recess 111a ranges from 5 µm to 10 µm. For example, the average one-dimensional size L1 of the bottom surface of the first recess 111a may be 5 µm, 6 µm, 7 µm, 8 µm, 9 µm, 10 µm, or the like. It is understandable that, the average one-dimensional size L1 of the bottom surface of the first recess 111a may also be other values within the above range, and may be specifically set according to actual requirements, which is not limited herein.

As shown in FIG. 5 and FIG. 6, if the average one-dimensional size L1 of the bottom surface of the first recess 111a is excessively small, for example, L1<5 µm, recombination of a part of the metallization region 11 not covered by the finger electrode 42 is increased, which is not favorable for passivation of the metallization region 11. If the average one-dimensional size L1 of the bottom surface of the first recess 111a is excessively large, for example, L1>10 µm, the surface area ratio in the metallization region 11 is small, which is not favorable for improving the performance of metal contact between the doped conductive layer 3 and the finger electrode 42.

In some embodiments, as shown in FIG. 3, FIG. 5 and FIG. 6, when the average one-dimensional size L1 of the bottom surface of the first recess 111a ranges from 5 µm to 10 µm, the metallization region 11 can obtain higher passivation quality and better performance of metal contact between the doped conductive layer 3 and the finger electrode 42, and thus obtain a higher open-circuit voltage and fill factor, thereby improving the conversion efficiency of the solar cell 100.

The bottom surface of the first recess 111a is a polygonal plane. In some embodiments, the bottom surface of the first recess 111a may be in at least one of a diamond shape, a square shape, a trapezoid shape, an approximate diamond shape, an approximate square shape, or an approximate trapezoid shape. It is understandable that, the bottom surface of the first recess 111a may be in other polygonal shapes, which is not limited herein.

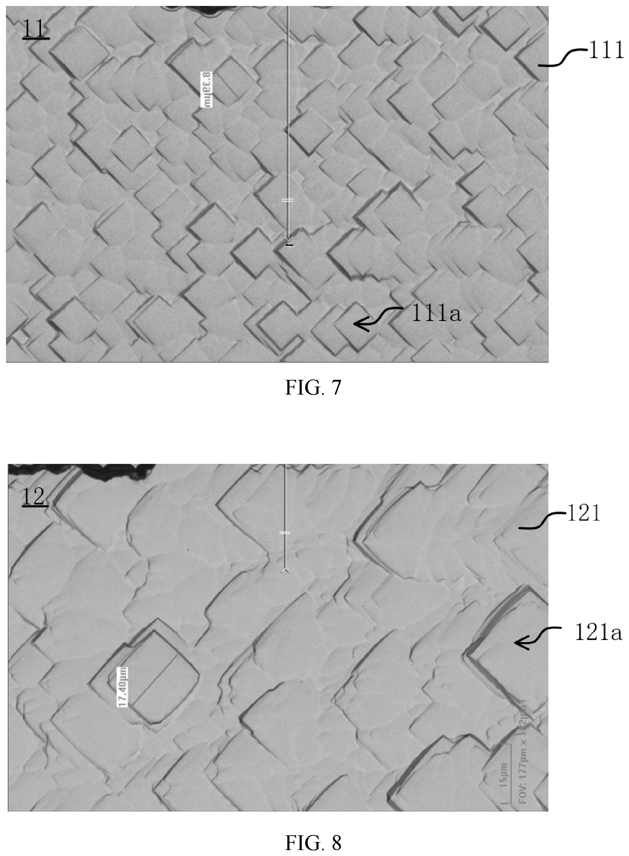

In some embodiments, as shown in FIG. 7, in the first texture structure 111, at least parts of projection of bottoms of at least two first recesses 111a in the thickness direction Z of the substrate 1 overlap with or abut against each other, so that the roughness of the surface of the metallization region 11 can be further increased, and thus the metallization region can be better filled with the metal paste, thereby further improving the performance of metal contact between the doped conductive layer 3 and the finger electrode 42 in the metallization region 11, and improving the conversion efficiency of the solar cell 100.

In some embodiments, as shown in FIG. 5 and FIG. 6, a depth H1 of the first recess 111a ranges from 0.05 µm to 2 µm. For example, the depth H1 of the first recess 111a may be 0.05 µm, 0.1 µm, 0.15 µm, 0.2 µm, or the like. It is understandable that, the depth H1 of the first recess 111a may be other values within the above range, and may be specifically set according to actual requirements, which is not limited herein.

In some embodiments, as shown in FIG. 5 and FIG. 6, when the depth H1 of the first recess 111a ranges from 0.05 µm to 2 µm, the metallization region 11 can be guaranteed to have a large surface area ratio, so that the performance of metal contact between the doped conductive layer 3 and the finger electrode 42 in the metallization region 11 can be improved,. In addition, the recombination on the surface of the metallization region 11 is prevented from being increased, which is beneficial to improving the passivation effect of the metallization region 11.

In some embodiments, as shown in FIG. 3, FIG. 5 and FIG. 6, the average one-dimensional size L2 of the bottom surface of the second recess 121a ranges from 10 µm to 25 µm. Further, the average one-dimensional size L2 of the bottom surface of the second recess 121a ranges from 15 µm to 25 µm. For example, the average one-dimensional size L2 of the bottom surface of the second recess 121a may be 10 µm, 12 µm, 15 µm, 20 µm, 22 µm, 24 µm, 25 µm, or the like. It is understandable that, the average one-dimensional size L2 of the bottom surface of the second recess 121a may also be other values within the above range, and may be specifically set according to actual requirements, which is not limited herein.

As shown in FIG. 5 and FIG. 6, if the average one-dimensional size L2 of the bottom surface of the second recess 121a is excessively small, for example, L2<10 µm, the surface area ratio of the non-metallization region 12 is increased, and the recombination in this region is increased, which is not favorable for passivation of the non-metallization region 12. If the average one-dimensional size L2 of the bottom surface of the second recess 121a is excessively large, for example, L2>25 µm, the preparation difficulty of the second recess 121a is increased, and during the preparation process of the second recess 121a, an arc-shaped convex structure may be formed on the surface of the non-metallization region 12, which is not favorable for passivation of the non-metallization region 12.

In some embodiments, as shown in FIG. 3, FIG. 5 and FIG. 6, when the average one-dimensional size L2 of the bottom surface of the second recess 121a ranges from 10 µm to 25 µm, the preparation difficulty of the non-metallization region 12 can be reduced, the preparation efficiency can be improved, and the non-metallization region 12 can obtain higher passivation quality, thus improving the conversion efficiency of the solar cell 100.

The bottom surface of the second recess 121a is a polygonal plane. In some embodiments, the bottom surface of the second recess 121a may be in at least one of a diamond shape, a square shape, a trapezoid shape, an approximate diamond shape, an approximate square shape, and an approximate trapezoid shape. It is understandable that, the bottom surface of the second recess 121a may be in other polygonal shapes, which is not limited herein.

In some embodiments, as shown in FIG. 8, in the second texture structure 121, at least parts of projection of bottoms of at least two second recesses 121a in the thickness direction Z of the substrate 1 overlap with or abut against each other, so that the roughness of the surface of the non-metallization region 12 can be increased, and the internal reflectivity of the non-metallization region 12 is improved, which is favorable for improving the conversion efficiency of the solar cell 100.

In some embodiments, as shown in FIG. 5 and FIG. 6, a depth H2 of the second recess 121a ranges from 0.05 µm to 2 µm. For example, the depth H2 of the second recess 121a may be 0.05 µm, 0.1 µm, 0.15 µm, 0.2 µm, or the like, and certainly, the depth H2 of the second recess 121a may be other values within the above range, may be specifically set according to actual requirements, and is not limited herein.

In some embodiments, as shown in FIG. 5 and FIG. 6, when the depth H2 of the second recess 121a ranges from 0.05 µm to 2 µm, the roughness of the second texture structure 121 of the non-metallization region 12 can be controlled within a required range, and the recombination of the surface of the non-metallization region 12 can be prevented from being increased, which is beneficial to improving the passivation effect of the non-metallization region 12.

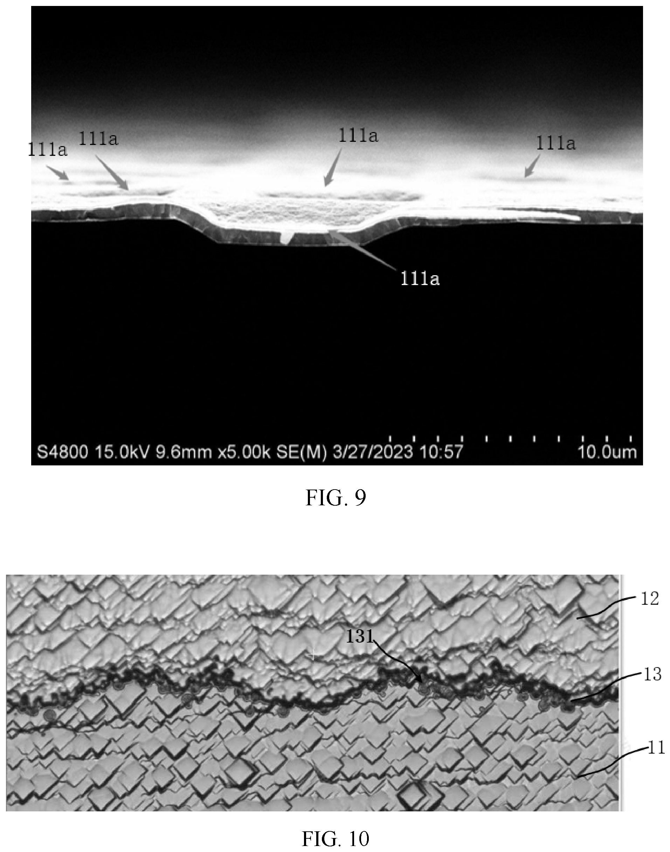

In some embodiments, as shown in FIG. 6 and FIG. 9, a sectional shape of the first recess 111a and/or the second recess 121a is one or more of a diamond shape, a square shape, or a trapezoid shape, so as to reduce the preparation difficulty of the first recess 111a and/or the second recess 121a, and thus providing design freedom for the solar cell 100. It is understandable that, the sectional shape of the first recess 111a and/or the second recess 121a may be other shapes, and may be specifically set according to actual requirements, which is not limited herein.

In some embodiments, as shown in FIG. 2, FIG. 3, FIG. 5 and FIG. 6, a top surface of the metallization region 11 protrudes relative to a top surface of the non-metallization region 12 in the thickness direction Z of the substrate 1.

In some embodiments, as shown in FIG. 2, FIG. 3, FIG. 5 and FIG. 6, the top surface of the metallization region 11 protrudes relative to the top surface of the non-metallization region 12, so that the metallization region 11 can be used as the basis for alignment of the first electrode 4 during the process of preparing the first electrode 4, thereby facilitating the preparation of the first electrode 4 and improving the preparation efficiency of the solar cell 100.

In some embodiments, as shown in FIG. 2, FIG. 3, FIG. 5 and FIG. 6, in the thickness direction Z of the substrate 1, a height difference H3 between the top surface of the metallization region 11 and the top surface of the non-metallization region 12 ranges from 1 µm to 10 µm. For example, the height difference H3 between the top surface of the metallization region 11 and the top surface of the non-metallization region 12 may be 1 µm, 2 µm, 4 µm, 6 µm, 8 µm, 10 µm, or the like. It is understandable that, the height difference H3 between the top surface of the metallization region 11 and the top surface of the non-metallization region 12 may be other values within the above range, and may be specifically set according to actual requirements, which is not limited herein.

As shown in FIG. 2, FIG. 3, FIG. 5 and FIG. 6, if the height difference H3 between the top surface of the metallization region 11 and the top surface of the non-metallization region 12 is excessively large, for example, H3>10 µm, the overall thickness of the substrate 1 is increased. When the first surface 1a of the substrate 1 is passivated, the passivation layer of a transition region 13 between the metallization region 11 and the non-metallization region 12 may generate an uneven phenomenon, thereby affecting the collection of the carriers. If the height difference H3 between the top surface of the metallization region 11 and the top surface of the non-metallization region 12 is excessively small, for example, H3<1 µm, it is not favorable for identifying alignment of the metallization region 11 and the first electrode 4, and thus adversely affecting the preparation of the first electrode 4.

In some embodiments, as shown in FIG. 2, FIG. 3, FIG. 5 and FIG. 6, when the height difference H3 between the top surface of the metallization region 11 and the top surface of the non-metallization region 12 ranges from 1 µm to 10 µm, the first surface 1a can obtain higher passivation quality, thus facilitating the collection of the carriers, and the metallization region 11 can be used as the basis for alignment of the first electrode 4 during the process of preparing the first electrode 4, thereby facilitating the preparation of the first electrode 4. In addition, a reflective surface of the first surface 1a can be increased, so as to improve the optical internal reflection effect of the first surface 1a of the solar cell 100, and thereby improving the conversion efficiency of the solar cell 100.

In some embodiments, as shown in FIG. 2, FIG. 3 and FIG. 10, the first surface 1a further includes the transition region 13. The transition region 13 is connected between the metallization region 11 and the non-metallization region 12, and the transition region 13 is provided with at least one hole 131.

In some embodiments, as shown in FIG. 2, FIG. 3 and FIG. 10, the arrangement of the holes 131 in the transition region 13 facilitates transmission of the carriers, and can improve the utilization rate of the incident light on the first surface 1a, which is favorable for improving the performance of the solar cell 100.

In some embodiments, as shown in FIG. 10, a diameter of the hole 131 ranges from 0.5 µm to 5 µm. For example, the diameter of the hole 131 may be 0.5 µm, 1 µm, 2 µm, 3 µm, 4 µm, 5 µm, or the like. It is understandable that, the diameter of the hole 131 may be other values within the above range, and may be specifically set according to actual requirements, which is not limited herein.

In some embodiments, as shown in FIG. 10, when the diameter of the hole 131 ranges from 0.5 µm to 5 µm, the arrangement of the transition region 13 facilitates the transmission of the carriers, improves the utilization rate of the incident light of the first surface 1a, which can facilitate the improvement of the performance of the solar cell 100, and can ensure that the first surface 1a can obtain higher passivation quality. If the diameter of the hole 131 is excessively large, for example, greater than 5 µm, passivation of the transition region 13 may be affected. If the diameter of the hole 131 is excessively small, for example, less than 0.5 µm, the above effect cannot be achieved.

In some embodiments, when the first texture structure 111 and the second texture structure 121 are prepared by laser etching, the first texture structure 111 is usually formed on the first surface 1a by laser etching. Subsequently, the second texture structure 121 is formed by performing laser etching on the non-metallization region 12 to remove redundant film parts. During the preparation of the solar cell 100, the holes 131 are formed at an edge near the metallization region 11 when laser is applied to the non-metallization region 12.

In some other embodiments, when the first texture structure 111 and the second texture structure 121 are prepared by chemical etching, the first texture structure 111 is usually formed on the first surface 1a by laser etching, the metallization region 11 is then subjected to mask tooling (for example, the metallization region 11 is subjected to mask tooling by using a chemical reagent). Subsequently, the non-metallization region 12 not covered by the mask is etched by using a chemical reagent to form the second texture structure 121. During the preparation of the solar cell 100, the holes 131 are formed by etching at the edge near the metallization region 11 when the non-metallization region 12 is etched by the chemical reagent.

In some embodiments, as shown in FIG. 10, a depth of the hole 131 ranges from 0.5 µm to 2 µm. For example, the depth of the hole 131 may be 0.5 µm, 1 µm, 1.5 µm, 2 µm, or the like. It is understandable that, the depth of the hole 131 may be other values within the above range, and may be specifically set according to actual requirements, which is not limited herein.

In some embodiments, as shown in FIG. 10, when the depth of the hole 131 ranges from 0.5 µm to 2 µm, the arrangement of the transition region 13 facilitates the transmission of the carriers, improves the utilization rate of the incident light of the first surface 1a, which can facilitate the improvement of the performance of the solar cell 100, and can ensure that the first surface 1a can obtain higher passivation quality. If the depth of the hole 131 is excessively large, for example, greater than 2 µm, the passivation of the transition region 13 may be affected. If the depth of the hole 131 is excessively small, for example, less than 0.5 µm, the above effect cannot be achieved.

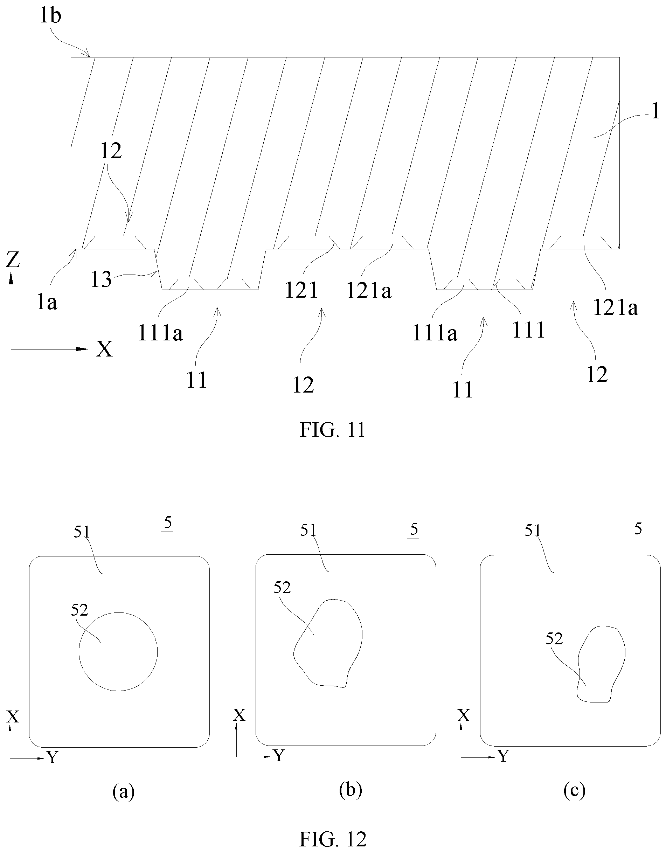

For example, as shown in FIG. 11, the transition region 13 is arranged obliquely relative to the metallization region 11 and the non-metallization region 12. For example, as shown in FIG. 6, the transition region 13 may be substantially perpendicular to the metallization region 11 and the non-metallization region 12. This structure arrangement can provide more design freedom for the solar cell 100 and reduce the preparation difficulty of the solar cell 100, which is favorable for improving the passivation quality of the first surface 1a.

In some embodiments, as shown in FIG. 5, the solar cell 100 further includes first passivation layers 5 arranged on the side of the doped conductive layer 3 away from the tunnel dielectric layer 2 and on a surface of the second texture structure 121.

In some embodiments, as shown in FIG. 5, the first passivation layer 5 can perform good passivation on a surface of a side of the doped conductive layer 3 away from the substrate 1 and the surface of the second texture structure 121, thus reducing density of the interface part, reducing recombination of the minority carriers, improving the transmission efficiency of the carriers at the interface, and thereby improving the efficiency of the solar cell 100. For example, the first passivation layer 5 may be deposited by a PECVD method. It is understandable that, the first passivation layer 5 may also be formed by other methods, such as an organic chemical vapor deposition method. The first passivation layer 5 may have a single-layer structure or a stacked-layer structure, and the thickness of each layer may be designed correspondingly. In some embodiments, the first passivation layer 5 may be any one or a combination of a silicon nitride layer, a silicon oxynitride layer, a silicon oxide layer, or an aluminium oxide layer. It is understandable that, the first passivation layer 5 may also be other types of passivation layers, which is not limited herein.

As shown in FIG. 12, the first passivation layer 5 includes a third region 51 and a fourth region 52, and a first passivation sub-layer 53 is arranged on the third region 51.

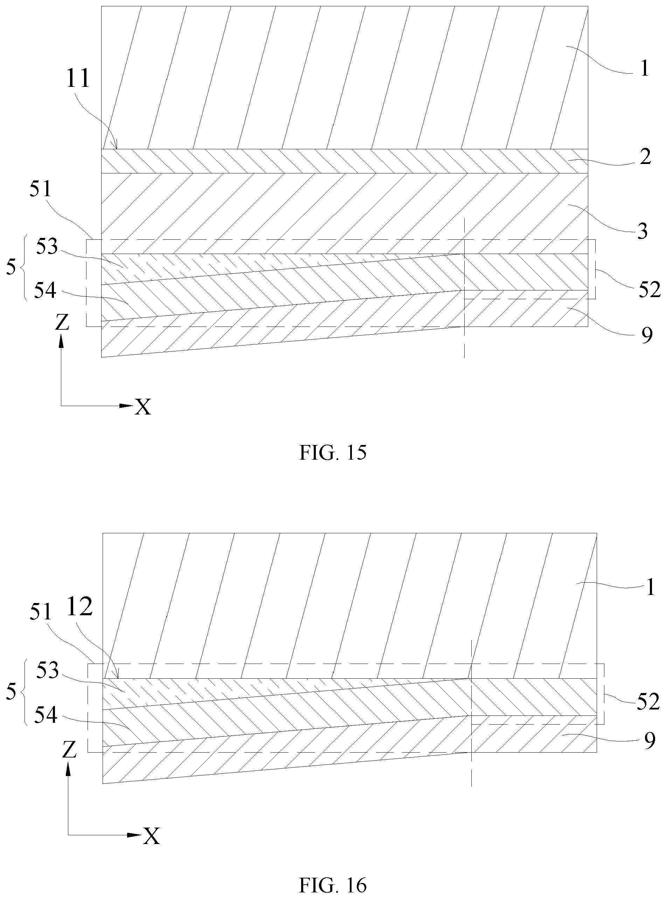

As shown in FIG. 5, FIG. 12, FIG. 13, FIG. 14, FIG. 15 and FIG. 16, if the first passivation sub-layers 53 are arranged in the third region 51 and the fourth region 52, that is, the first passivation sub-layers 53 are arranged on the side of the doped conductive layer 3 away from the tunnel dielectric layer 2, the first passivation sub-layers 53 are required to be separately deposited on the side of the doped conductive layer 3 away from the tunnel dielectric layer 2, which may bring low productivity and high preparation cost. If a second passivation layer 7 on the second surface 1b side of the solar cell 100 also includes the same film as the first passivation sub-layer 53, the passivation layers on the first surface 1a side and the second surface 1b side are required to be separately deposited due to their different thickness requirements, which results in complicated preparation processes, low productivity, and further increased preparation cost.

In the present disclosure, the first passivation sub-layer 53 is arranged in the third region 51 of the first passivation layer 5, so that the passivation effect of the first passivation layer 5 can be further improved, and the first passivation layer 5 and the second passivation layer 7 on the second surface 1b side can be simultaneously prepared, thereby reducing preparation processes of the solar cell 100, which can improve the preparation efficiency of the solar cell 100 and save the preparation cost.

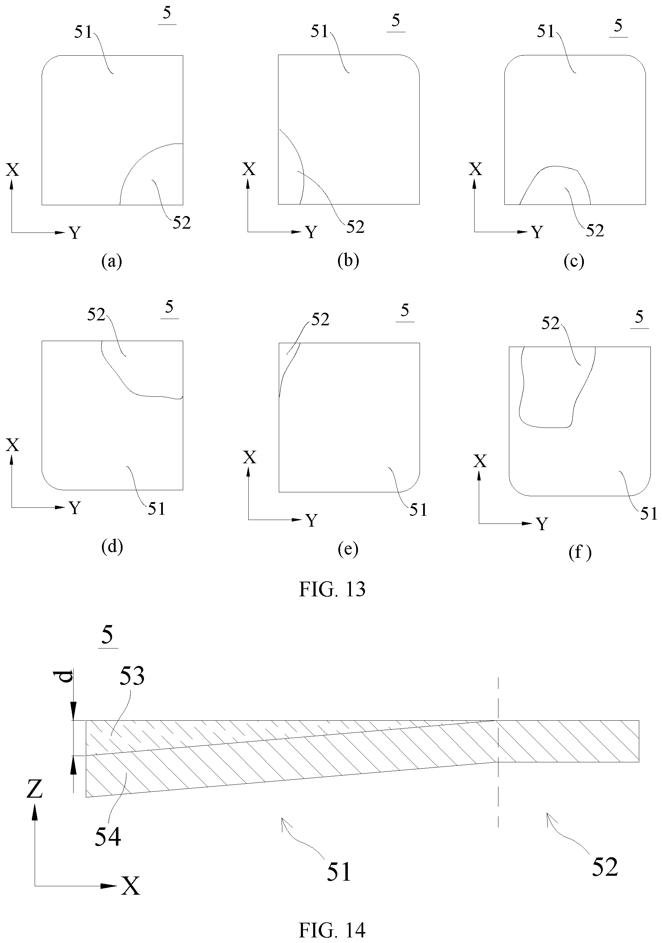

In some embodiments, as shown in FIG. 14 to FIG. 16, the thickness of the first passivation sub-layer 53 is gradually decreased in a direction from the third region 51 to the fourth region 52.

In some embodiments, as shown in FIG. 14 to FIG. 16, the entire third region 51 of the first passivation layer 5 of the solar cell 100 is thicker, and the fourth region 52 thereof is thinner, so that the passivation effect of the third region 51 of the first passivation layer 5 can be further improved, and recombination at the position of the solar cell 100 corresponding to the third region 51 is reduced, thereby further improving the photoelectric conversion efficiency of the solar cell 100.

Further, as shown in FIG. 14 to FIG. 16, the thickness d of the first passivation sub-layer 53 ranges from 1 nm to 5 nm. For example, the thickness d of the first passivation sub-layer 53 is 1 nm, 2 nm, 3 nm, 4 nm, 5 nm, or the like. It is understandable that, the thickness of the first passivation sub-layer 53 may also be other values within the above-mentioned range, and may be specifically set according to actual requirements, which is not limited herein.

If the thickness d of the first passivation sub-layer 53 is excessively large, for example, d>5 nm, the preparation time and material of the first passivation sub-layer 53 may be increased, which may adversely reduce the preparation efficiency and increasing the preparation cost. If the thickness d of the first passivation sub-layer 53 is excessively small, for example, d<1 nm, the passivation effect of the first passivation sub-layer 53 is poor.

In some embodiments, as shown in FIG. 14 to FIG. 16, when the thickness d of the first passivation sub-layer 53 satisfies the above-mentioned range, the first passivation sub-layer 53 can be conveniently prepared, the preparation efficiency can be improved, the preparation cost can be saved, the first passivation sub-layer 53 brings a good passivation effect, and the passivation effect of the third region 51 of the first passivation layer 5 can be improved, thereby improving the performance of the solar cell 100.

In some embodiments, as shown in FIG. 5, FIG. 14, FIG. 15 and FIG. 16, the first passivation sub-layer 53 may be an aluminium oxide layer.

In some embodiments, as shown in FIG. 5, FIG. 14, FIG. 15 and FIG. 16, aluminium oxide can improve the surface passivation effect of the solar cell 100, improve the photoelectric conversion efficiency of the solar cell 100, and facilitate simultaneous preparation of the first passivation sub-layer and the second passivation layer 7. In addition, the aluminium oxide has high stability and wear resistance, so that the surface of the solar cell 100 can be protected, and the solar cell 100 can be protected from corrosion, thus prolonging the service life of the solar cell 100. Therefore, when the first passivation sub-layer 53 is an aluminium oxide layer, better passivation and protection effects on the solar cell 100 can be brought, the efficiency of the solar cell 100 can be improved, and the service life of the solar cell 100 can be prolonged.

When the first passivation sub-layer 53 is an aluminium oxide layer, the first passivation sub-layer may be formed by an atomic layer deposition (ALD) technology, or other manners, which is not limited herein.

In some embodiments, as shown in FIG. 5, FIG. 14, FIG. 15 and FIG. 16, the first passivation layer 5 further includes a second passivation sub-layer 54, the second passivation sub-layer 54 is arranged in the third region 51 and the fourth region 52, and at least part of the second passivation sub-layer 54 and the first passivation sub-layer 53 are stacked on one another.

In some embodiments, as shown in FIG. 5, FIG. 14, FIG. 15 and FIG. 16, the arrangement of the second passivation sub-layer 54 can further improve the passivation effect of the third region 51 of the first passivation layer 5, and meanwhile can guarantee the passivation effect of the fourth region 52 of the first passivation layer 5, thereby guaranteeing the overall passivation effect of the first passivation layer 5, reducing the density of the interface part of the surface of the solar cell 100, reducing the recombination of the minority carriers, and improving the efficiency of the solar cell 100.

As shown in FIG. 5, FIG. 14, FIG. 15 and FIG. 16, the second passivation sub-layer 54 may be a silicon oxide layer, so as to reduce the preparation difficulty of the second passivation sub-layer 54 and improve the preparation efficiency. It is understandable that, the second passivation sub-layer 54 may be of other passivation film structures, which is not limited herein.

In some embodiments, a thickness of the second passivation sub-layer 54 may range from 1 nm to 10 nm, so as to avoid that the second passivation sub-layer 54 is excessively thin and cannot achieve passivation and protection functions, as well as to avoid that the second passivation sub-layer 54 is excessively thick to adversely affect the transmission efficiency of the carriers.

In some embodiments, as shown in FIG. 5, FIG. 14, FIG. 15 and FIG. 16, the solar cell 100 further includes an antireflection layer 9 arranged on a side of the first passivation layer 5 away from the substrate 1.

In some embodiments, as shown in FIG. 5, FIG. 14, FIG. 15 and FIG. 16, the antireflection layer 9 reduces or eliminates light reflected by the surface of the solar cell 100 and increases the amount of transmitted light, thereby further improving the photoelectric conversion efficiency of the solar cell.

The antireflection layer 9 may be a silicon nitride layer, thereby further lowering the preparation difficulty of the solar cell 100, and improving the preparation efficiency. It is understandable that, the antireflection layer 9 may be a silicon oxynitride layer, or have a single-layer or stacked-layer structure made of silicon nitride and silicon oxynitride, or have another antireflection film structure, which is not limited herein.

In some embodiments, a thickness of the antireflection layer 9 can range from 30 nm to 150 nm, thereby avoiding that the antireflection layer 9 is excessively thin and cannot achieve the function of reducing or eliminating the light reflected by the surface of the solar cell 100, as well as to avoid that the antireflection layer 9 is excessively thick to reduce the amount of the transmitted light to affect the photoelectric conversion efficiency of the solar cell.

It should be noted that the solar cell 100 may be a monolithic solar cell without cutting, or a half-cut solar cell or a segmented solar cell formed by equally cutting a prepared monolithic solar cell into two, three, four or more cut solar cells along the thickness direction Z, which is not limited herein.

For example, as shown in FIG. 12, in some embodiments, the solar cell 100 may be a monolithic solar cell, and the first passivation layer 5 may have a structure in which the third region 51 is connected to a periphery of the fourth region 52 as shown in FIG. 12(a) to FIG. 6(c). For example, as shown in FIG. 13, in some embodiments, the solar cell 100 may be a half-cut solar cell or a segmented solar cell formed by equally cutting a prepared monolithic solar cell into two, three, four or more cut solar cells in the thickness direction Z, and the first passivation layer 5 may have a structure in which the third region 51 and the fourth region 52 are sequentially arranged in the first direction X of the solar cell 100 as shown in FIG. 13(a) to FIG. 7(f).

The half-cut solar cell or the segmented solar cell shown in FIG. 13 can be formed by cutting the monolithic solar cell shown in FIG. 12. For example, the segmented solar cell shown in FIG. 13(a) is formed by cutting the monolithic solar cell shown in FIG. 12(a).

In some embodiments, as shown in FIG. 12 to FIG. 14, in the thickness direction Z of the solar cell 100, a ratio of the surface area of the fourth region 52 to that of the first passivation layer 5 is greater than 0 and smaller than or equal to 40%. For example, the ratio of the surface area of the fourth region 52 to the surface area of the first passivation layer 5 is 10%, 20%, 30%, or 40%. It is understandable that, the ratio of the surface area of the fourth region 52 to the surface area of the first passivation layer 5 may be other values in the above range, and may be specifically set according to actual requirements, which is not limited herein.

If the ratio of the surface area of the fourth region 52 to the surface area of the first passivation layer 5 is excessively large, for example, larger than 40%, the area of the third region 51 for arranging the first passivation sub-layer 53 is excessively small, thereby easily affecting the passivation effect of the first passivation sub-layer 53. Therefore, when the ratio of the surface area of the fourth region 52 to the surface area of the first passivation layer 5 is within the above range, the arranged first passivation sub-layers 53 can be reduced while the good passivation effect of the first passivation layer 5 is guaranteed, thereby improving the preparation efficiency and saving the preparation cost.

In addition, a shape of the fourth region 52 may be a circle, an ellipse, or other irregular shapes, so as to further providing more freedom for the structural design of the solar cell 100, which is not limited herein.

It should be noted that the solar cell 100 may be a double-sided TOPCon cell or a single-sided TOPCon cell.

In some embodiments, as shown in FIG. 5, the solar cell 100 is a single-sided TOPCon cell. As an example, the tunnel oxide passivation contact structure is arranged on a back surface of the solar cell. The solar cell 100 further includes an emitter 6, a second passivation layer 7 and a second electrode 8.

In the thickness direction Z of the solar cell 100, the emitter 6 is formed above or inside the second surface 1b of the substrate 1. A doping element in the emitter 6 and the doping element in the substrate 1 have different conductivity types, so that the emitter and the substrate can jointly form a PN junction. For example, when the substrate 1 is an N-type silicon substrate, the emitter 6 may be a P-type emitter. For another example, when the substrate 1 is a P-type silicon substrate, the emitter 6 may be an N-type emitter. In addition, for example, the emitter 6 may be formed by diffusing the doping element into the substrate 1 on the second surface 1b side of the substrate 1, and for example, when the substrate 1 is an N-type silicon substrate, the P-type emitter 6 may be formed by performing boron diffusion on the substrate 1. For example, the emitter 6 may also be made of doped polycrystalline silicon, microcrystalline silicon or amorphous silicon having a conductivity type opposite to the doping element of the substrate 1. For example, when the substrate 1 is an N-type silicon substrate, a tunnel layer and a polycrystalline silicon, microcrystalline silicon or amorphous silicon layer may be formed on the second surface 1b of the substrate 1 by a LPCVD method, a PECVD method, or the like. The emitter 6 may be formed by doping a P-type doping element into the polycrystalline silicon, microcrystalline silicon or amorphous silicon layer.

The second passivation layer 7 is arranged on a surface of a side of the emitter 6 away from the substrate 1. The second passivation layer 7 can provide good passivation effect on the surface of the side of the emitter 6 away from the substrate 1, so as to reduce the density of the interface part, thereby reducing the recombination of the minority carriers, improving the transmission efficiency of the carriers at the interface, and thus improving the efficiency of the solar cell 100. The second passivation layer 7 can further reduce or eliminate the light reflected by the surface of the solar cell and increase the amount of transmitted light, thereby further improving the photoelectric conversion efficiency of the solar cell. For example, the second passivation layer 7 may be deposited by a PECVD method. It is understandable that, the second passivation layer 7 may also be formed by other methods, such as an organic chemical vapor deposition method. The second passivation layer 7 may have a single-layer structure or a stacked-layer structure, and the refractive index and the thickness of each layer may be designed correspondingly. In some embodiments, the second passivation layer 7 may be any one or a combination of a silicon nitride layer, a silicon oxynitride layer or a silicon oxide layer. It is understandable that, the second passivation layer 7 may also be other types of passivation layers, which is not limited herein.

The second electrode 8 is arranged on the side of the emitter 6 away from the substrate 1, and the second electrode 8 is electrically connected with the emitter 6. In some embodiments, the second electrode 8 may be in direct or indirect contact with the emitter 6 to form an electrical connection. The second electrode 8 is configured to collect and gather the current of the solar cell 100. For example, the second electrode 8 may be prepared by screen printing and sintering. In some embodiments, metal paste for preparing the second electrode 8 may be one or more of aluminium, silver, gold, nickel, molybdenum, or copper, which is not limited herein.

In some embodiments, the solar cell is a double-sided TOPCon cell, and for example, both a front surface (light receiving surface) and a back surface (backlight surface) of the solar cell are provided with tunnel oxide passivation contact structures. When the solar cell is a double-sided TOPCon cell, the front surface and the back surface thereof may have the same film structure. That is, the film structure on the second surface 1b of the substrate 1 may be the same as that on the first surface 1a.

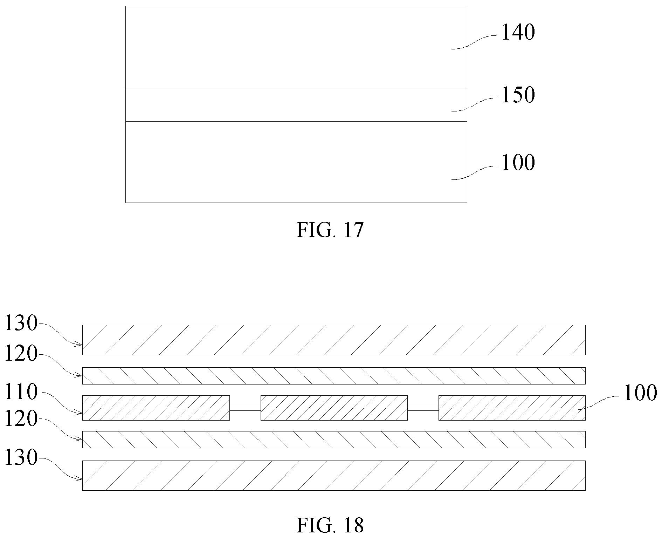

The present disclosure further provides a tandem solar cell, as shown in FIG. 17, including a bottom cell, a top cell 140 and an intermediate connection layer 150, wherein the bottom cell is the solar cell 100 according to any one of the above embodiments. The top cell 140 is one of a perovskite solar cell, a donor-acceptor cell, a cadmium telluride (CdTe) solar cell, a copper indium gallium selenide (CIGS) solar cell or a gallium arsenide (GaAs) solar cell. The intermediate connection layer 150 is connected between the bottom cell and the top cell 140. Since the solar cell 100 has the above technical effects, a photovoltaic module including the solar cell 100 should also have the above technical effects, which are not repeated herein.

As shown in FIG. 17, a band gap width of the top cell 140 is larger than that of the bottom cell, so that the tandem solar cell can have a wider spectral response range by stacking the top cell 140 above the bottom cell, thereby utilizing solar energy to the maximum extent and improving the efficiency of the solar cell.

The intermediate connection layer 150 is typically a tunnel junction or a quite thin metal or transparent electrode composite layer. For example, the intermediate connection layer 150 may be made of a transparent conductive oxide (TCO) having good optoelectronic characteristics, high photon permeability, and high electrical conductivity, thereby enabling the top cell 140 and the bottom cell to maintain good ohmic contact.

When the solar cell 100 is the bottom cell, the first electrode 4 or the second electrode 8 of the solar cell 100 may also be used as the intermediate connection layer 150 configured to be electrically connected with the top cell 140. Furthermore, when the solar cell 100 is the bottom cell, the passivation layer and the electrode on a side of the solar cell 100 connected with the top cell 140 may be removed or are not provided with the passivation layer and the electrode, so that the solar cell 100 is connected with the top cell 140 through the intermediate connection layer 150.

The present disclosure further provides a photovoltaic module, as shown in FIG. 18, including a solar cell string 110, a packaging layer 120 and a cover plate 130. The solar cell string 110 is formed by connecting a plurality of solar cells 100 according to any one of the above embodiments. The packaging layer 120 is configured to cover a surface of the solar cell string 110. The cover plate 130 is configured to cover a surface of the packaging layer 120 away from the solar cell string 110. Since the solar cell 100 has the above technical effects, the photovoltaic module including the solar cell 100 should also have the above technical effects, which are not repeated herein.

As shown in FIG. 18, the solar cells 100 are electrically connected in a monolithic or plural-segment form to form a plurality of solar cell strings 110, and the plurality of solar cell strings 110 are electrically connected in series and/or in parallel. In some embodiments, the plural solar cell strings 110 may be electrically connected by conductive strips. The packaging layer 120 covers the front surface and the back surface of the solar cell. In some embodiments, the packaging layer 120 may be an organic packaging adhesive film, such as an ethylene vinyl acetate (EVA) adhesive film, a polyolyaltha olfin (POE) adhesive film, a polyethylene terephthalate (PET) adhesive film, a polyvinyl butyral (PVB) adhesive film, or the like. The cover plate 130 may be a glass cover plate, a plastic cover plate, or the like having a light transmitting function. In some embodiments, a surface of the cover plate 130 facing the packaging layer 120 may be a concave-convex surface, so as to increase the utilization rate of incident light.

The invention also comprises the following embodiments:
Embodiment 1: A solar cell (100), comprising: a substrate (1), wherein a first surface (1a) of the substrate (1) is divided as a plurality of metallization regions (11) and non-metallization regions (12) in an alternating arrangement; wherein the metallization regions (11) each have a first texture structure (111), the first texture structure (111) includes a first recess (111a), the non-metallization regions (12) each have a second texture structure (121), the second texture structure (121) includes a second recess (121a), and an average one-dimensional size of a bottom surface of the first recess (111a) is smaller than an average one-dimensional size of a bottom surface of the second recess (121a); and wherein the metallization region includes first regions (112) and second regions (113), the first regions (112) are arranged at intervals along a first direction (X), the second regions (113) are connected between adjacent first regions (112), and the second regions (113) are arranged at intervals along a second direction (Y), and an included angle is formed between the first direction (X) and the second direction (Y); a tunnel dielectric layer (2) arranged on a surface of the first texture structure (111); a doped conductive layer (3) arranged on a side of the tunnel dielectric layer (2) away from the substrate (1); and at least one first electrode (4) comprising a plurality of finger electrodes (42), wherein the finger electrodes (42) are arranged on a side of the doped conductive layer (3) away from the tunnel dielectric layer (2) and electrically connected to the doped conductive layer (3), wherein the finger electrodes (42) are arranged at intervals along the first direction (X) and correspond to the first regions (112).
Embodiment 2: The solar cell (100) according to embodiment 1, wherein the average one-dimensional size of the bottom surface of the first recess (111a) ranges from 5 µm to 10 µm; and a depth of the first recess (111a) ranges from 0.05 µm to 2 µm.
Embodiment 3: The solar cell (100) according to embodiment 1 or 2, wherein the average one-dimensional size of the bottom surface of the second recess (121a) ranges from 10 µm to 25 µm; and a depth of the second recess (121a) ranges from 0.05 µm to 2 µm.
Embodiment 4: The solar cell (100) according to any one of embodiments 1 to 3, wherein in the first texture structure (111), at least part of projections of bottoms of at least two first recesses (111a) in a thickness direction of the substrate (1) overlap with or abut against each other.
Embodiment 5: The solar cell (100) according to any one of embodiments 1 to 4, wherein in the second texture structure (121), at least part of projections of bottoms of at least two second recesses (121a) in a thickness direction of the substrate (1) overlap with or abut against each other.
Embodiment 6: The solar cell (100) according to any one of embodiments 1 to 5, wherein the at least one first electrode (4) further comprises a plurality of bus electrodes (41), and the bus electrodes (41) are arranged on sides of the finger electrodes (42) away from the doped conductive layer (3) and electrically connected to the finger electrodes (42); and the bus electrodes (41) are arranged at intervals along the second direction (Y) and correspond to the second regions (113).
Embodiment 7: The solar cell (100) according to any one of embodiments 1 to 6, wherein a top surface of the metallization region (11) protrudes outward relative to a top surface of the non-metallization region in the thickness direction of the substrate (1).
Embodiment 8: The solar cell (100) according to any one of embodiments 1 to 7, wherein in the thickness direction of the substrate (1), a height difference between a top surface of the metallization region and a top surface of the non-metallization region ranges from 1 µm to 10 µm.
Embodiment 9: The solar cell (100) according to any one of embodiments 1 to 8, wherein the first surface (1a) further includes transition regions, the transition regions are connected between the metallization regions (11) and the adjacent non-metallization regions (12), and the transition regions are provided with holes; a diameter of each of the holes ranges from 0.5 µm to 5 µm; a depth of each of the holes ranges from 0.5 µm to 2 µm.
Embodiment 10: The solar cell (100) according to embodiment 9, wherein the transition regions are arranged obliquely relative to the metallization regions (11) and the non-metallization regions (12).
Embodiment 11: The solar cell (100) according to any one of embodiments 1 to 10, wherein a sectional shape of the first recess (111a) and/or the second recess (121a) is one or more of a diamond shape, a square shape, or a trapezoid shape.
Embodiment 12: The solar cell (100) according to any one of embodiments 1 to 11, further comprising a first passivation layer (5) arranged on a side of the doped conductive layer (3) away from the tunnel dielectric layer (2) and on a surface of the second texture structure (121).
Embodiment 13: The solar cell (100) according to embodiment 12, wherein the first passivation layer (5) further includes third regions and fourth regions, and the third regions are provided with a first passivation sub-layer.
Embodiment 14: A tandem solar cell, comprising: a bottom cell, wherein the bottom cell is the solar cell (100) according to any one of embodiments 1 to 13; a top cell (140), wherein the top cell is one of a perovskite solar cell (100), a donor-acceptor cell, a cadmium telluride solar cell (100), a copper indium gallium selenide solar cell (100) or a gallium arsenide solar cell (100); and an intermediate connection layer connected between the bottom cell and the top cell.
Embodiment 15: A photovoltaic module, comprising: at least one solar cell (100) string formed by connecting a plurality of solar cells (100), wherein at least one of the solar cells is the solar cell (100) according to any one of embodiments 1 to 13, a packaging layer configured to cover a surface of the at least one solar cell string, and a cover plate configured to cover a surface of the packaging layer away from the at least one solar cell string.

The above description only shows specific implementations of embodiments of the present disclosure, but the protection scope of the embodiments of the present disclosure is not limited thereto. Therefore, the protection scope of embodiments of the present disclosure should be subject to the protection scope of the appended claims.

## Claims

1. A solar cell (100), comprising:
a substrate (1), wherein a first surface (1a) of the substrate is divided as a plurality of metallization regions (11) and non-metallization regions (12) in an alternating arrangement; wherein the metallization regions each have a first texture structure (111), the first texture structure includes a first recess (111a), the non-metallization regions each have a second texture structure (121), the second texture structure includes a second recess (121a), and the average of a one-dimensional size of a bottom surface of the first recess is smaller than the average of said one-dimensional size of a bottom surface of the second recess; and wherein each metallization region includes first regions (112) and second regions (113), the first regions are arranged at intervals along a first direction (X), the second regions are connected between adjacent first regions, and the second regions are arranged at intervals along a second direction (Y), and the first direction intersects the second direction;
a tunnel dielectric layer (2) arranged on a first surface of each metallization region;
a doped conductive layer (3) arranged on a side of the tunnel dielectric layer away from the substrate; and
at least one first electrode (4) comprising a plurality of finger electrodes (42), wherein the finger electrodes are arranged on a side of the doped conductive layer away from the tunnel dielectric layer and electrically connected to the doped conductive layer, wherein the finger electrodes are arranged at intervals along the first direction and correspond to the first regions,
wherein the first surface further includes transition regions (13), the transition regions are connected between the metallization regions and the adjacent non-metallization regions.

2. The solar cell according to claim 1, wherein the average one-dimensional size of the bottom surface of the first recess ranges from 5 µm to 10 µm; and
a depth of the first recess ranges from 0.05 µm to 2 µm.

3. The solar cell according to claim 1 or 2, wherein the average one-dimensional size of the bottom surface of the second recess ranges from 10 µm to 25 µm; and
a depth of the second recess ranges from 0.05 µm to 2 µm.

4. The solar cell according to any one of claims 1 to 3, wherein in the first texture structure, at least part of projections of bottoms of at least two first recesses in a thickness direction of the substrate overlap with or abut against each other.

5. The solar cell according to any one of claims 1 to 4, wherein in the second texture structure, at least part of projections of bottoms of at least two second recesses in a thickness direction of the substrate overlap with or abut against each other.

6. The solar cell according to any one of claims 1 to 5, wherein the at least one first electrode further comprises a plurality of bus electrodes (41), and the bus electrodes are arranged on sides of the finger electrodes away from the doped conductive layer and electrically connected to the finger electrodes; and
the bus electrodes are arranged at intervals along the second direction and correspond to the second regions.

7. The solar cell according to any one of claims 1 to 6, wherein a top surface of the metallization region protrudes outward relative to a top surface of the non-metallization region in the thickness direction of the substrate.

8. The solar cell according to any one of claims 1 to 7, wherein in the thickness direction of the substrate, a height difference between a top surface of the metallization region and a top surface of the non-metallization region ranges from 1 µm to 10 µm.

9. The solar cell according to any one of claims 1 to 8, wherein the transition regions are provided with holes;
a diameter of each of the holes ranges from 0.5 µm to 5 µm;
a depth of each of the holes ranges from 0.5 µm to 2 µm.

10. The solar cell according to any one of claims 1 to 9, wherein the transition regions are arranged obliquely relative to the metallization regions and the non-metallization regions.

11. The solar cell according to any one of claims 1 to 10, wherein a width W1 of the doped conductive layer located above the first region is greater than a width W2 of the finger electrode.

12. The solar cell according to any one of claims 1 to 11, wherein a width W1 of the doped conductive layer located above the first region ranges from 100 µm to 600 µm, and a width of the doped conductive layer located above the second region ranges from 150 µm to 600 µm.

13. The solar cell according to any one of claims 1 to 12, further comprising a first passivation layer arranged on a side of the doped conductive layer away from the tunnel dielectric layer and on a surface of the second texture structure, wherein the first passivation layer further includes third regions (51) and fourth regions (52), and the third regions are provided with a first passivation sub-layer (53).

14. A tandem solar cell, comprising:
a bottom cell (100), wherein the bottom cell is the solar cell according to any one of claims 1 to 13;
a top cell (140), wherein the top cell is one of a perovskite solar cell, a donor-acceptor cell, a cadmium telluride solar cell, a copper indium gallium selenide solar cell or a gallium arsenide solar cell; and
an intermediate connection layer (150) connected between the bottom cell and the top cell.

15. A photovoltaic module, comprising:
at least one solar cell string (110) formed by connecting a plurality of solar cells, wherein at least one of the solar cells is the solar cell according to any one of claims 1 to 13,
at least one packaging layer (120) configured to cover a surface of the at least one solar cell string, and
at least one cover plate (130) configured to cover a surface of the at least one packaging layer away from the at least one solar cell string.
